# EUROPEAN PATENT APPLICATION

(11) **EP 1 574 902 A1**
(43) Date of publication of application: **14.09.2005**
(21) Application number: 03811897.2
(22) Date of filing: 14.11.2003
(51) Int. Cl.: G03F 7/004, G03F 7/022, G03F 7/20, G03F 7/40, G03F 1/08

(54) **METHOD OF PATTERN FORMATION USING ULTRAHIGH HEAT RESISTANT POSITIVE PHOTOSENSITIVE COMPOSITION**

(30) Priority: 27.11.2002 JP 2002344146
(71) Applicant: AZ Electronic Materials (Japan) K.K., Tokyo 113-0021 (JP)
(72) Inventor: IGAWA, Akihiko, Ogasa-gun, Shizuoka 437-1496 (JP); YAMAMOTO, Atsuko, Ogasa-gun, Shizuoka 437-1496 (JP)
(74) Representative: Isenbruck, Günter
(86) International application number: PCT/JP2003/014507
(87) International publication number: WO 2004/049067

(57) **Abstract**

In the process wherein a high heat resistance is required for a photoresist pattern such as a manufacture of a TFT active matrix substrate, a super high heat resistant positive pattern is formed using a positive-working photosensitive composition. The pattern forming method of the present invention comprises the steps of: applying a photosensitive composition onto a substrate, comprising (a) an alkali-soluble resin, (b) a photosensitizer having a quinone diazide group, (c) a photo acid generator, (d) a crosslinking agent and (e) a solvent; then exposing the substrate to light through a mask; forming a positive image by developing and removing the exposed area to light; exposing a whole area of the positive image to light; and post-baking, if necessary. In the case of using 1,2-naphthoquinone-4-sulfonyl compound as the photosensitizer having a quinone diazide group, the above component (c) can be omitted since this compound also functions as a photo acid generator of the component (c).

## Description

### Technical field of the invention

The present invention relates to a photoresist pattern forming method to be used upon manufacturing a semiconductor device, a flat panel display (FPD) and so on, and particularly to a method for forming a super high heat resistant resist pattern which is suitable for a 4 mask process using a half tone mask (a resist pattern forming method using a reduced number of photo-masks), that is one of the methods of a TFT (Thin Film Transistor) active matrix manufacturing process requiring a high heat resistant property of a photoresist or for a formation of a corrugated reserve material for a reflective-type of TFT.

### Background Art

In the various fields such as manufacture of semiconductor integrated circuits such as LSI, production of a display face of FPD, manufacture of a circuit substrate of a thermal head and so on, photolithographic technology has so far been employed for forming microelements or for conducting fine processing. In the photolithographic technology, a positive- or negative-working photosensitive composition is used to form a resist pattern. Of these photosensitive compositions, a composition comprising an alkali-soluble resin and a compound containing a quinone diazide group is widely used as a positive-working resist. This composition is described with various kinds of compositions in a lot of literature (patent literature Nos. 1 to 4 to be referred below, for example) as "novolak resin/quinone diazide compound", for example. Research and development works have so far been conducted for these compositions comprising an alkali-soluble resin and a compound containing a quinone diazide group from the viewpoints of both a novolak resin and a photosensitizer.
[Patent Literature No. 1]
   Japanese examined patent publication number Sho. 54-23570 (page-1)
[Patent Literature No. 2]
   Japanese examined patent publication number Sho 56-30850 (page-1)
[Patent Literature No. 3]
   Japanese laid-open patent publication number Sho 55-73045 (pages-1 to 4)
[Patent Literature No. 4]
   Japanese laid-open patent publication number Sho 61-205933 (pages-1, 3 to 5)
   On the other hand, altogether 5 pieces or more of photo masks have so far been used in the array substrate manufacturing process of TFT active matrix substrates. However the application of a higher number of masks causes a tendency of high manufacturing costs, a tendency to require a long process time, and a lower yield upon manufacturing. In order to solve the problem, a process using a small number of masks, i.e. a 4-mask process is being examined. Manufacturing method of a liquid crystal display device of high aperture ratio to use a small number of photo masks is already being proposed as referred to patent literature No. 5, for example.
[Patent Literature No. 5]
   Japanese laid-open patent publication number 2002-98996 (pages-2 to 5)

In the mask saving process described above, generally the processes of forming a resist pattern with a step by half-tone exposure to light and of making dry-etching are required. Therefore a heat treatment for a photoresist pattern is conducted in order to improve a dry-etching resistance of a resist film upon the dry-etching. The heat resistant temperature required at this stage is generally 130°C or higher and then there is a problem of pattern deterioration in the heating process for the positive-working photoresist so far being applied. For that reason, an improved process such as a manufacture by applying milder etching conditions or an improvement of heat resistance of positive-working photoresist materials are required.

In the case of a reflective type of TFT, it is necessary to prepare a reserve material with a shape such as a corrugated shape, followed by spattering to cover thereon with a high light reflective metal such as aluminum. In this process, in order to control the water absorption or metal ion migration, or in a manufacturing process of a reflective type of TFT panels, the reserve material with corrugated shape is exposed to organic solvents such as MIBK (methyl isobutyl ketone), THF (tetrahydrofuran), NMP (N-methyl-2-pyrrolidone) and so on. Therefore post-baking is required in order to provide the reserve material with a resistance to those solvents. However a positive-working photoresist so far being applied is likely to flow when post-baked at 130°C or higher and then there is a problem to get out of a necessary original corrugated shape.

Referring to the situation described above, an object of the present invention is to provide a pattern forming method using a positive-working photosensitive composition by which a good and super high heat resistant positive pattern can be formed in a process wherein a high heat resistance of a photoresist pattern is required such as manufacturing a TFT active matrix substrate.

The present invention also has the object to provide a pattern forming method using a positive-working photosensitive composition by which a pattern having a good and super-heat resistant pattern with steps or corrugated pattern can be formed using a half tone mask in a process wherein a high heat resistance of a photoresist pattern is required such as manufacturing a TFT active matrix substrate.

### Disclosure of the Invention

As a result of eager studies and examinations, the present inventors found that the above-described object can be attained by using a specific positive-working photosensitive composition, exposing a whole area to light after exposure to light and development thereof, and if necessary heat-treating (post-baking) to reach to the present invention.

It means that the present invention relates to a pattern forming method which is characterized in comprising [1] a step of applying on a substrate material a photosensitive composition comprising (a) an alkali-soluble resin, (b) a photosensitizer having a quinone diazide group, (c) a photo acid generator, (d) a crosslinking agent and (e) a solvent, to form a photosensitive layer, [2] a step of exposing the photosensitive layer to light through a mask, [3] a step of removing the exposed area of the photosensitive layer by development to form a positive image, and then [4] a step of exposing a whole area of the photosensitive layer to light.

The present invention also relates to a pattern forming method described above which is characterized in that in the pattern forming method, a photosensitizer having a quinone diazide group (b) and a photo acid generator (c) have an absorption activity at the same exposure wavelength and a whole area exposure is conducted at the exposure wavelength where both said photosensitizer and said photo-acid generator have an absorbing activity.

Furthermore the present invention relates to a pattern forming method which is characterized in comprising [1] a step of applying on a substrate material a photosensitive composition comprising (a)an alkali-soluble resin, (f) a compound having a quinone diazide group and functioning as a photosensitizer and a photo-acid generator, (d) a crosslinking agent and (e) a solvent, to form a photosensitive layer, [2] a step of exposing the photosensitive layer to light through a mask, [3] a step of removing the exposed area of the photosensitive layer by development to form a positive image, and [4] a step of exposing a whole area of the positive image to light.

The present invention also relates to a pattern forming method according to any one of above described pattern forming methods, which is characterized in that after the step of exposing the whole area of the photosensitive layer to light, [5] heat treatment (post-baking) is carried out.

The present invention also relates to a pattern forming method according to any one of above described pattern forming methods, which is
characterized in that the alkali-soluble resin is at least one species selected from the group consisting of novolak resins, polyvinyl phenol resins and acrylic resins.

The present invention also relates to a pattern forming method according to any one of above-described pattern forming methods, which is characterized in that the mask used at the exposure step described before is a mask having a half-tone region which is partially made 10 to 90 % of transmittance at a light transmission region by being equipped with a semi-transparent film or installing a slit or a mesh having a dimension of not more than a resolution of the exposure device.

### Brief description of the drawing

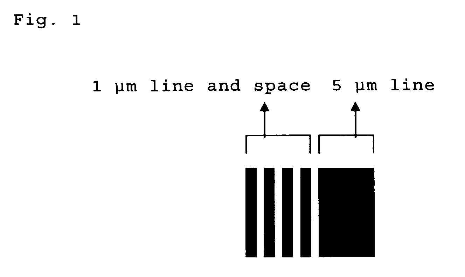

Figure 1 shows an example of a mask having a half tone region.

### Detailed explanation of the Invention

Hereinafter, the present invention will be further described in more detail.

A novolak resin which is used in the photosensitive composition of the present invention may be any one of novolak resins which are used in a photosensitive composition containing an alkali-soluble resin and a photosensitizer having a quinone diazide group so far publicly known and is not particularly limited. The novolak resin which is preferably used in the present invention is obtained by polycondensing one kind of phenols or a mixture of plural kinds thereof with aldehydes such as formalin.

As phenols constituting said novolak resin, there may be illustrated with, for example, phenol, p-cresol, m-cresol, o-cresol, 2,3-dimethylphenol, 2,4-dimethylphenol, 2,5-dimethylphenol, 2,6-dimethylphenol, 3,4-dimethylphenol, 3,5-dimethylphenol, 2,3,4-trimethylphenol, 2,3,5-trimethylphenol, 3,4,5-trimethylphenol, 2,4,5-trimethylphenol, methylene-bisphenol, methylene-bis p-cresol, resorcinol, catechol, 2-methylresorcinol, 4-methylresorcinol, o-chlorophenol, m-chlorophenol, p-chlorophenol, 2,3-dichlorophenol, m-methoxyphenol, p-methoxyphenol, p-butoxyphenol, o-ethylphenol, methylphenol, p-ethylphenol, 2,3-diethylphenol, 2,5-diethylphenol, p-isopropylphenol, α-naphthol, β-naphthol, and the like. These are used singly or as a mixture of two or more kinds thereof.

As aldehydes, there may be illustrated with paraformaldehyde, acetaldehyde, benzaldehyde, hydroxybenzaldehyde, chloroacetaldehyde and so on besides formalin. These are used singly or as a mixture of two or more kinds thereof.

The weight average molecular weight of the novolak resin used in the photosensitive composition of the present invention, as determined by polystyrene standards, is preferably 5,000 to 100,000, more preferably 5,000 to 50,000.

An alkali-soluble resin may be illustrated with a vinyl phenol type of resin, or an acrylic type of resin besides a novolak resin. As the alkali-soluble acrylic type of resin, there are exemplified a copolymer of unsaturated carboxylic acid such as acrylic acid or methacrylic acid and acrylic esters and/or methacrylic esters.

As the photosensitizer containing a quinone diazide group which is used for the photosensitive composition of the present invention, any photosensitizer containing a quinone diazide group can be used and particularly one obtained by a reaction between quinone diazide sulfonic acid halide such as naphthoquinone diazide sulfonic acid chloride or benzoquinonediazide sulfonic acid chloride and low or high molecular weight compounds containing functional groups which can be condensed with these acid halides is preferred. As functional groups which can be condensed with these acid halides, a hydroxyl group or an amino group can be exemplified and the hydroxyl group is particularly preferred. As low molecular compounds containing a hydroxyl group, there are exemplified hydroquinone, resorcinol, 2,4-dihydroxybenzophenone, 2,3,4-trihydroxybenzophenone, 2,4,6-trihydroxybenzophenone, 2,4,4'-trihydroxybenzophenone, 2,3,4,4'-tetrahydroxybenzophenone, 2,2',4,4'-tetrahydroxybenzophenone, 2,2',3,4,6'-pentahydroxybenzophenone and so on.

Examples of the high molecular compounds containing a hydroxyl group include novolak resin and polyvinylphenol and so on. A reactant between qunione diazide sulfonic acid halide and a compound having a hydroxyl group may be single kind of a esterified compound or a mixture of two or more kinds having different esterification ratios. The photosensitizer containing a quinone diazide group of the present invention is used preferably at 1 to 30 parts by weight relative to 100 parts by weight of the resin components in the photosensitive composition.

The photo acid generator (a compound generating an acid by irradiation of radiation) which is used in the photosensitive composition of the present invention may be any compound generating an acid by irradiation of radiation. These compounds may be preferably illustrated why one so far used as a photo acid generator in a chemically amplified resist. As these photo acid generators, there may be illustrated an onium salt such as iodonium salt, sulfonium salt, diazonium salt, ammonium salt, pyrridinium salt and so on, a compound containing halogen such as hydrocarbon compound containing a haloalkyl group, heterocyclic compound containing a haloalkyl group (for example, halomethyl triazine derivative and so on), diazoketone compound such as 1,3-diketo-2-diazo compound, diazobenzoquinone compound, diazonaphthoquinone compound, sulfone compound such as β-ketosulfone, β-sulfonylsulfone and so on, and sulfonic acid compound such as alkylsulfonic ester, haloalkylsulfonic ester, aryl sulfonic ester, iminosulfonate, and so on. These can be used singly or as a mixture of two or more kinds thereof.

Examples of photo acid generators which are particularly preferably used in the photosensitive composition of the present invention include a triazine type of acid generator represented by 2-[2-(5-methylfuran-2-yl)ethenyl]-4,6-bis-(trichloromethyl)-s-triazine or a cyano type of acid generator represented by 5-methylsulfonyloxyimino-5H-thiophene-2-ylidene-2-methylphenyl acetonitrile. The formulated amount of the photo acid generator is usually 0.05 to 9 parts by weight relative to 100 parts by weight of an alkali-soluble resin, preferably 0.5 to 3.0 parts by weight.

Furthermore when a 1,2-naphthoqinonediazide-sulphonyl compound is used as a compound containing a quinone diazide group, this compound works as a photosensitizer as well as a photo acid generator and therefore it is possible to use one substance as the above described (b) and (c) components.

As the crosslinking agent used in the present invention, there may be any one which crosslinks and hardens an alkali-soluble resin by receiving an action of an acid which is generated at an area irradiated by radiation and not particularly be limited. As the crosslinking agents, there may be raised a various kind of crosslinking agents such as a melamine-, benzoguanamine- or urea-type of crosslinking agent, a multi-functional epoxide group containing compound and so on.

As low molecular crosslinking agents among melamine, benzoguanamine and urea types of crosslinking agents, there are exemplified methylolated melamines or alkyl ethers thereof such as hexamethylol melamine, pentamethylol melamine, tetramethylol melamine, hexamethoxymethyl melamine, pentamethoxymethyl melamine, or tetramethoxymethyl melamine, methylolated benzoguanamines and alkyl ethers thereof such as tetramethylol benzoguanamine, tetramethoxymethyl benzoguanamine, or trimethoxymethyl benzoguanamine, N,N-dimethylol urea or dialkyl ether thereof, 3,5-bis (hydroxymethyl) perhydro-1,3,5-oxadiazine-4-on (dimethylol urone) or alkyl ether thereof, tetramethylolglyoxaldiureine or tetramethylol ether thereof, 2,6-bis(hydroxymethyl)4-methylphenol or alkyl ether thereof, 4-tert-butyl-2,6-bis(hydroxymethyl)phenol or alkyl ether thereof, and 5-ethyl-1,3-bis(hydroxymethyl)perhydro-1,3,5-triazine-2-on (N-ethyldimethylol triazone) or alkyl ether thereof as preferable ones.

As high molecular crosslinking agents among melamine, benzoguanamine and urea types of crosslinking agents, there are exemplified alkoxyalkylated amino resins such as alkoxyalkylated melamine resins, alkoxyalkylated urea resins, which can be exemplified with methoxymethylated melamine resins, ethoxymethylated melamine resins, propoxymethylated melamine resins, butoxymethylated melamine resins, methoxymethylated urea resins, ethoxymethylated urea resins, propoxymethylated urea resins, and butoxymethylated urea resins as a preferable one. A multi functional epoxide group containing compound represents a compound which contains one or more of benzene ring or heterocyclic ring in a molecule and besides two or more of epoxide groups.

As a solvent which is applied in the present invention, there are illustrated ethylene glycol monoalkyl ethers such as ethylene glycol monomethyl ether, ethylene glycol monoethyl: ether, etc.; ethylene glycol monoalkyl ether acetates such as ethylene glycol monomethyl ether acetate, ethylene glycol monoethyl ether acetate, etc.; propylene glycol monoalkyl ethers such as propylene glycol monomethyl ether, propylene glycol monoethyl ether, etc.; propylene glycol monoalkyl ether acetates such as propylene glycol monomethyl ether acetate, propylene glycol monoethyl ether acetate, etc.; lactic esters such as methyl lactate, ethyl lactate, etc.; aromatic hydrocarbons such as toluene, xylene, etc.; ketones such as methyl ethyl ketone, 2-heptanone, cyclohexanone, etc.; amides such as N,N-dimethylacetamide, N-methylpyrrolidone (NMP), etc.; lactones such as γ-butyrolactone, and the like. These solvents may be used singly or as a mixture of two or more kinds thereof.

In the photosensitive composition of the present invention there may be incorporated, if necessary, adhesion aids, surfactants and so on. Examples of the adhesion aids include alkylimidazolines, butyric acid, alkyl acids, polyhydroxystyrene, polyvinyl methyl ether, t-butylnovolak, epoxysilane, epoxy polymers, silanes and so on and examples of the surfactants include nonionic surfactants such as polyglycols and the derivatives thereof, i.e., polypropylene glycol or polyoxyethylene lauryl ether, and so on; fluorine-containing surfactants such as Fluorad (trade name; product of Sumitomo 3M Co., Ltd.), Megafac (trade name; product of Dai-nippon Ink & Chemicals, Inc.), Surflon (trade name; product of Asahi Glass Company, Ltd.) and organosiloxane surfactants such as KP341 (trade name; product of S h in-Etsu Chemical Co., Ltd).

By the way, in Japanese Patent publication laid open No. Hei 6-35183 (1994), there is described a color filter preparation method using a composition for forming a color filter comprising a hardenable resin by acid, a quinone diazide compound, a crosslinking agent, a photo acid generator, a dye and a solvent. This method has an object to obtain a color filter being excellent in resolution, heat resistance and so on. However the composition is neither one which realizes a high resolution and a super high heat resistance which are required in manufacturing of a semiconductor or TFT and so on such as the present invention nor one which can form a pattern having a various kind of shape or profile, for example step form, corrugated shape and so on according to the object such as the present invention. The reason thereof is assumed as follows. It means that in the composition for forming a color filter described before, since dyes are used as one of the film forming components, a radiation used upon pattern-wise exposure to light is absorbed by the dyes. As the radiation does not reach to the bottom of the film, so the resolution is reduced. In the composition for forming a color filter described before, it is not an obstacle to obtain a pattern having a dimension of a few hundred microns required for a color filter, however the composition is not able to be applied to a pattern formation required for manufacturing a semiconductor or TFT array which requires a resolution of from a few tens to a few microns or sub microns. And also upon a whole area exposure to light, since a radiation is absorbed on the way to the bottom of the film of the composition, a necessary acid is not generated on the bottom area of the film. Therefore the composition is not sufficiently crosslinked and in the result the heat resistance of the film is reduced. Furthermore dyes are likely to have a high sublimation property. When the dyes are removed from the film, not only it contaminates the equipments in the process but also the film itself becomes micro porous to deteriorate a resistant property to solvents or to an etching liquid. Even if it is not a sublimated dye, as a heat resistant property of the dye is low, a heat resistant property of film is reduced. The present invention does not use dyes even as an optional component. It is, therefore, essentially different from the composition for forming a color filter described before and then it becomes possible to realize a resist pattern having a high resolution and a super high heat resistance which are required in a manufacturing of a semiconductor or TFT and so on.

The pattern forming method of the present invention will be indicated through processes. First the photosensitive composition described before is applied on a substrate material such as a silicon wafer or a glass substrate and so on by spin coating or slit coating and so on. The substrate material may be ones wherein a silicon oxide film, a metal film such as aluminum, molybdenum, and chromium, a metal oxide film such as ITO, furthermore a semiconductor element or a circuit pattern are installed onto the surface of the substrate material if necessary. The coating method is not limited to the ones described before concretely but can be any coating methods so far applied when applying a photosensitive composition. After applying a photosensitive composition on a substrate material, the substrate is heated up to the temperature between 70°C and 110°C by a convection type of oven or a hot plate and so on (pre-baking), a solvent component therein is removed to form a film of the photosensitive composition described before on a substrate material. This substrate material is exposed to light for patterning through a desired mask. A wavelength of an exposure to light at this time may be any one such as a single wavelength such like g-line (436nm), h-line (405nm), i-line (365nm), KrF (248nm), ArF (193nm), a mixed wavelength of g-line and h-line or a mixture of g-line, h-line and i-line called "broad band" which are applied so far upon exposing a photosensitive composition to light.

After the pattern-wise exposure to light, an exposed area is dissolved out by developing with an alkali developer and only an unexposed area remaines to provide with a positive pattern. The alkali developer is usually an aqueous solution of a quaternary amine salt such as tetramethylammonium hydroxide and so on or an aqueous solution of an inorganic hydroxide such as sodium hydroxide or potassium hydroxide. The reason why the exposed area is dissolved out into the alkali developer and the unexposed area remaines on a substrate is that a photosensitizer having a quinone diazide group of the component (b) is changed to a carboxylic acid by the exposure to light and the carboxylic acid is alkali-soluble. At the same time although an acid is generated from an acid generator of the component (c) at the exposed area, this acid itself hardly influence on a pattern-wise exposure to light.

Next a whole area exposure to light at the same wavelength as the one used upon the patterning exposure to light by not using a mask or by using a blank mask (all light pass through) is conducted on the patterning substrate where a development is completed. After the whole area exposure to light is completed, the substrate material is heated at the temperature of 110°C to 160°C by a convection type of oven or a hot plate and so on (post-baking) to make the film baked and solidified. Herewith the unexposed area upon a first patterning exposure to light is exposed to light, and an acid is generated from an acid generator of the component (c) in the unexposed are. By the catalytic action of the acid, a crosslinking reaction is caused between an alkali-soluble resin of the component (a) and a crosslinking agent of the component (d) to form a hard film.

Since the crosslinking is conducted by getting the heat of post-baking, a base resin becomes solidified by keeping a shape formed by development without flowing. Although there happened to be a problem such that a pattern was likely to become deteriorated or rounded when the positive-working photosensitive composition so far applied and the process so far applied are used and the pattern formed thereby is heated at about 120°C or higher, such phenomenon does not happen in the present invention. Furthermore according to the present invention, a high heat resistance after post-baking can be realized not only for an usual pattern such as a line and space pattern, a dotted pattern or a hole pattern but also for a patterning containing an uneven (concavity-convex) form which is formed by remaining a resist film in a halfway thickness using a mask having a partial half tone parts or for a patterning of a corrugated shape.

The half tone parts described before in the mask can be formed, for example either by putting (installing) a semi-light-transmissible film which is prepared by, for example, amorphous silicon film, silicon nitride film or chromium film having an adequate thickness onto the determined area of the mask or by installing a slit or mesh pattern having a dimension below a resolution limit of an exposure device onto the determined area to make a transmittance of a light transmissible area from 10% to 90%. When forming a pattern having a corrugated shape, a line and a space pattern having a dimension below a resolution limit of an exposure device and in the vicinity of the resolution limit may be installed onto a mask, for example.

In the above description, an example of a photosensitive composition containing a photosensitizer and a photo acid generator was shown. However a heat resistant pattern can also be formed in the same process as described above when applying single compound having the functions both of a photosensitizer and a photo acid generator in the present invention. In addition, in the above description, an example using a photosensitizer and a photo acid generator which have an absorbing activity against a same exposure wavelength was shown. In this way when both a photosensitizer and a photo acid generator have an absorbing activity against a same exposure wavelength, a pattern-wise exposure to light and a whole area exposure to light can be implemented using the same light-exposure device. Therefore there is no need to prepare two kinds of light-exposure devices in that case and it would be preferable. However a pattern forming method of the present invention is not limited to this one and it may be the case where a photosensitizer and a photo acid generator do not have an absorbing activity against the same exposure wavelength. In this case, a pattern-wise exposure to light and a whole area exposure to light may be conducted at different light-exposure wavelengths according to photosensitizing wavelengths of a photosensitizer and a photo acid generator.

### Best mode for practicing the invention

The present invention will now be described more specifically by reference to Examples which, however, are not to be construed to limit the instant invention in any way.

### Synthesis Example 1 (Synthesis of a novolak resin)

100 parts by weight of mixed cresols wherein the ratio of m-cresol/p-cresol is 6/4, 56 parts by weight of 37% by weight of formaldehyde, and 2 parts by weight of oxalic acid were charged and were reacted at the reaction temperature of 100°C for 5 hours in the conventional manner. The weight average molecular weight of the resulting novolak resin was 15,200 as determined by polystyrene standards.

### Synthesis Example 2 (Synthesis of a photosensitizer)

2,3,4-trihydroxybenzophenone and 1,2-naphthoquinone diaizde-5-sulfonylchloride were dissolved in dioxane at 1/2.0 feeding ratio (in molar ratio) and were esterified in the conventional manner using triethylamine as a catalyst. According to a measurement of the resulting ester by HPLC (High Performance Liquid Chromatography), the ester contained 29% diester and 63% triester.

### Synthesis Example 3 (Synthesis of a photosensitizer and a photo acid generator, concurrently)

2,3,4-trihydroxybenzophenone and 1,2-naphthoquinone diazide-4-sulfonylchloride were dissolved in dioxane at 1/2.0 feeding ratio (in molar ratio) and were esterified in the conventional manner using triethylamine as a catalyst. According to a measurement of the resulting ester by HPLC (High Performance Liquid Chromatography), the ester contained 25% diester and 61% triester diester

### Example 1

100 parts by weight of novolak resin obtained by the Synthesis Example 1, 17 parts weight of photosensitizer obtained by the Synthesis Example 2, 1 part by weight of 2-[2-(5-methylfurane-2-yl)ethenyl]-4,6-bis-(trichloromethyl)-s-triazine as a photo acid generator, and 5 parts by weight of Cymel 300 (manufactured by Mitsui Cytech) which is methoxymethyl melamine resin as a crosslinking agent were dissolved into propylene glycol monomethyl ether acetate. After incorporating thereto 500 ppm of a fluorine containing surfactant, Fluorad F-472 (manufactured by Sumitomo 3M) in order to prevent radial wrinkles generated on a resist film upon spin coating, so called striation, the solution was stirred and then filtered through a 0.2-µm filter to prepare a photosensitive composition of the present invention. This composition was spin-coated on a 4-inch silicon wafer, and pre-baked on a hot plate at 100°C for 90 seconds to obtain a 3-µm thick resist film. This resist film was pattern-wise exposed to light by a stepper FX-604F manufactured by Nikon having g+h lines mixture wavelength through a mask and was developed by paddle development method using a 2.38 weight-% aqueous solution of tetramethylammonium hydroxide for 60 seconds. At this time the pattern-wise exposure to light was conducted at an optimal sensitivity with an exposure energy volume by which a 5-µm line and space pattern with 1:1 ratio of a mask was developed as wide as a mask design. After the development, a section of the 5-µm line and space pattern was observed by SEM (Scanning Electronic Microscope). The result was shown in Table 1 (after development). As being obvious from Table 1, a rectangular pattern was formed normally.

A whole area exposure to light was conducted on the developed substrate using the same light-exposure device as one used in the patterning light-exposure step through a blank mask (all light pass through). After the whole exposure to light, the substrates were heated up on a hot plate up to 120°C, 140°C or 160°C, respectively for 90 seconds to conduct a post-baking. Each section of patterns was observed by SEM after post-bakings were conducted at the temperatures described above. The results were shown in Table 1. As shown in Table 1, a rectangular shape was maintained after baking at 140°C, and a top area became slightly rounded after baking at 160°C. As the result, it was confirmed that a high heat resistance of the pattern was maintained.

### Comparative Example 1

The same pattern formation and a pattern form observation as in Example 1 were conducted except for using a photosensitive composition which does not contain 2-[2-(5-methylfurane-2-yl)ethenyl]-4,6-bis-(trichloromethyl)-s-triazine used as an acid generator in the composition of Example 1. The results were shown in Table 1. As shown in Table 1, a rectangular pattern was formed after development without problems. However in this example the top area became rounded by the post-baking at 120°C, the bottom of a pattern began to flow to extend over at 140°C and the lines were stacked together completely by flow of the pattern at 160°C. A sufficient heat resistance of the pattern was not obtained in this example.

### Comparative Example 2

The same pattern formation and a pattern form observation as in Example 1 were conducted except for not conducting a whole area exposure to light. The results were shown in Table 1. As shown in Table 1, a rectangular pattern was formed after development without problems as almost the same as Comparative Example 1. However in this example the top area became rounded by the post-baking at 120°C, the bottom of a pattern began to flow to extend over at 140°C and the lines were stacked together completely by flow of the pattern at 160°C. A sufficient heat resistance of the pattern was not obtained in this example.

### Example 2

The same pattern formation and a pattern form observation as in Example 1 were conducted except for replacing the photosensitizer and the photo acid generator of the photosensitive composition in Example 1 with the substance synthesized according to Synthesis Example 3 which is able to be concurrently a photosensitizer and a photo acid generator. The results were shown in Table 1. As shown in Table 1, a rectangular shape was maintained by baking at 120°C and 140°C, and a top area became slightly rounded at 160°C as same as the result of Example 1. It was confirmed that a high heat resistance of the pattern was maintained in this example.

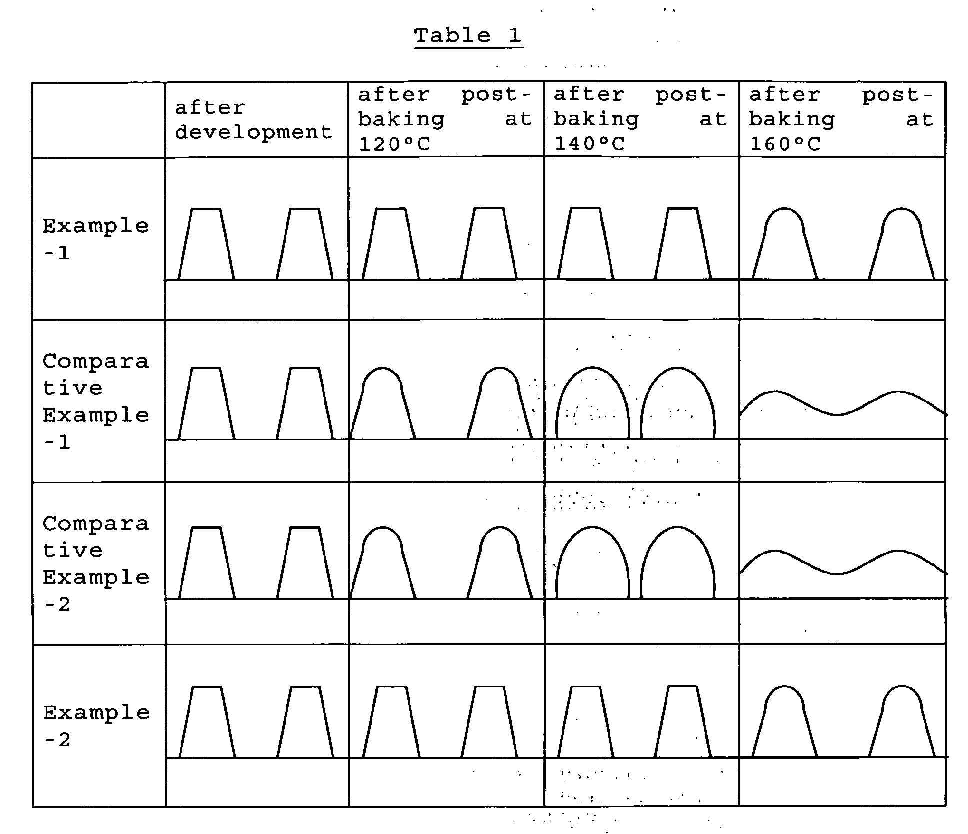

### Example 3

The same pattern formation and a pattern form observation as in Example 1 were conducted except for applying a light-exposure mask shown in Figure 1 which comprises a mask part composed by a 5 µm-width pattern and a half tone part composed by a 1.0 µm-width line and space pattern abutting thereto. The line and space pattern of 1.0 µm formed as a half tone part was far below 3.0 µm (by a line and space) which was the guaranteed resolution limit by the manufacturer of Nikon's stepper FX-604F, that was a light-exposure device used for an exposure to light. The results were shown in Table 2. As shown in Table 2, the half tone part was not resolved. Accordingly it provided with the same effectiveness as applying an exposure dose approximately by half, and a pattern having the desired profile with the remaining film thickness of a half height after development was formed. Besides no pattern form change was observed after any post-baking at 120°C, 140°C and 160°C and it was confirmed that a half-tone type profile having a sufficient heat resistance could be maintained.

### Comparative Example 3

A pattern formation and a pattern form observation were conducted in the same manner as in Example 3 except for not conducting a whole area exposure to light. The results were shown in Table 2. As shown in Table 2, a half tone pattern was formed without problems as Example 3 after development. However it flowed easily when being post-baked. As the result the half tone part and a completely unexposed part were connected to cause a profile which could not be applied for a half tone process.

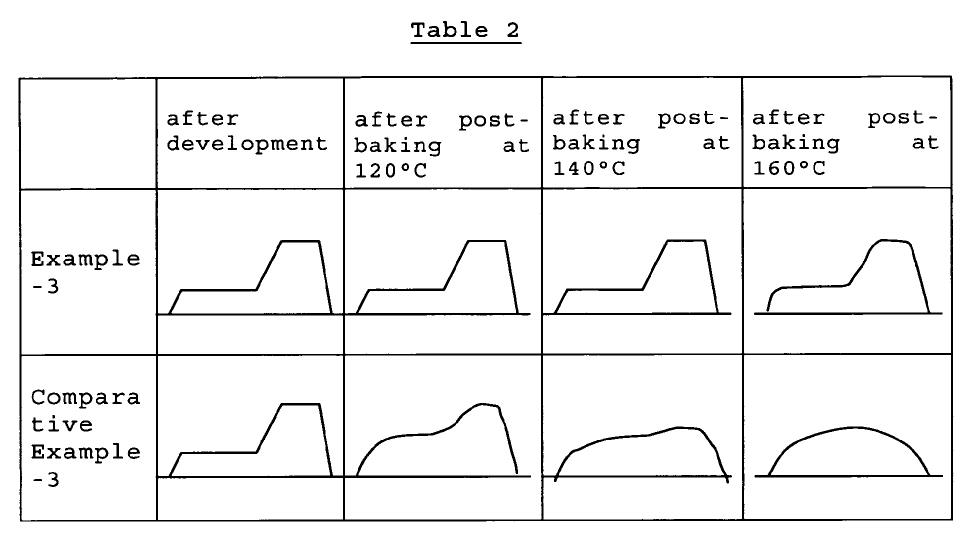

### Example 4

When devising a mask design applying the thinking way of the half tone mask used in Example 3, a high heat resistant pattern having a corrugated form can be obtained. It means that a pattern formation and a pattern form observation were conducted in the same manner as in Example 3 except for applying a mask with a line and space part having a resolution of 2.5 µm which is slightly below 3.0µm (by a line and space) as the guaranteed resolution limit by the manufacturer of Nikon's stepper FX-604F, that is a light-exposure device to be applied. The results were shown in Table 3. As shown in Table 3, the desired corrugated shaped pattern was obtained after development and the corrugated form was not collapsed in post-baking after a whole area exposure to light at each temperature of 120°C, 140°C and 160°C.

### Comparative Example 4

A pattern formation and a pattern form observation were conducted in the same manner as in Example 4 except for not conducting a whole area exposure to light. The results were shown in Table 3. As shown in Table 3, a corrugated form was formed without problems as was Example 4 after development. However it flowed easily when being post-baked, and the corrugated form could not be maintained.

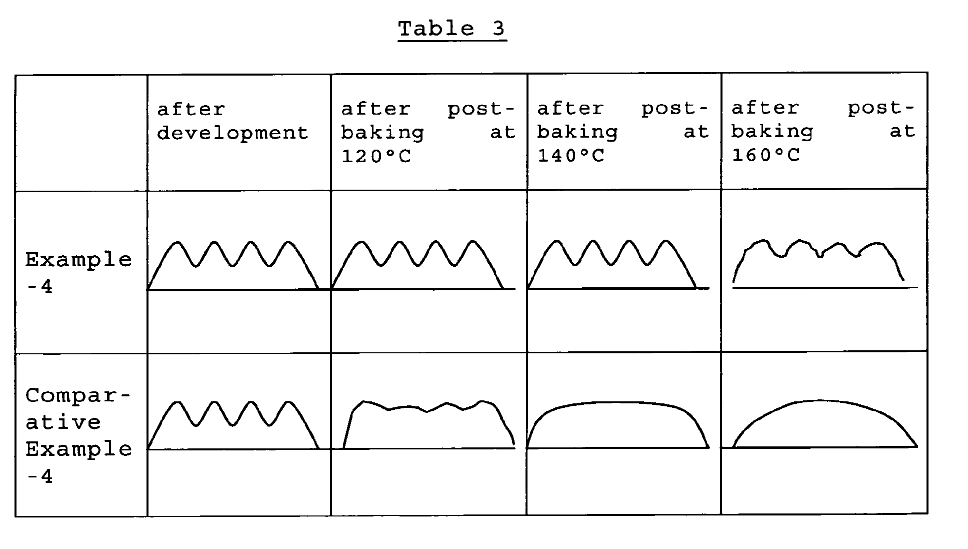

### Effects of the Invention

According to the present invention, it has become possible to form a super high heat resistant pattern which has not been realized by the composition or the process so far applied. Therefore it is possible not only to form a super high heat resistant pattern in a usual lithography but also to form a pattern which is excellent in a heat resistance and a dry-etching resistance in the specific applications such as a reserve material of a half tone process or a corrugated form.

## Claims

1. A pattern forming method which is **characterized in** comprising
[1] a step of applying on a substrate material a photosensitive composition comprising (a) an alkali-soluble resin, (b) a photosensitizer having a quinone diazide group, (c) a photo acid generator, (d) a crosslinking agent and (e) a solvent, to form a photosensitive layer,
[2] a step of exposing the photosensitive layer to light through a mask,
[3] a step of removing said exposed area by development to form a positive image, and then
[4] a step of exposing a whole area of the positive image to light.

2. The pattern forming method according to claim 1, **characterized in that** in the pattern forming method (b) a photosensitizer having a quinone diazide group and (c) a photo acid generator have an absorption activity at the same exposure wavelength and the whole area exposure is conducted at the exposure wavelength where both the photosensitizer and the photo-acid generator have an absorption activity.

3. A pattern forming method which is **characterized in** comprising
[1] a step of applying on a substrate material a photosensitive composition comprising (a) an alkali-soluble resin, (f) a compound having a quinone diazide group and functioning as a photosensitizer and a photo-acid generator, (d) a crosslinking agent and (e) a solvent, to form a photosensitive layer,
[2] a step of exposing the photosensitive layer to light through a mask,
[3] a step of removing said exposed area of the photosensitive layer by development to form a positive image, and then
[4] a step of exposing a whole area of the positive image to light.

4. A pattern forming method according to any one of claims 1 to 3, **characterized in that** [5] a heat treatment (post-baking) is carried out after the whole area exposure step described before.

5. A pattern forming method according to any one of claims 1 to 4, **characterized in that** said alkali-soluble resin is at least one species selected from the group consisting of novolak resins, polyvinyl phenolic resins and acrylic resins.

6. A pattern forming method according to any one of claims 1 to 5, **characterized in that** the mask used at the exposure step [2] is a mask having a half-tone region which is partially made 10 to 90 % of transmittance at a light transmission region by being equipped with a semi-transparent film or installing a slit or a mesh having a dimension of not more than a resolution of the exposure device.
